# EUROPÄISCHE PATENTANMELDUNG

(11) **EP 3 486 673 A1**
(43) Veröffentlichungstag der Anmeldung: **22.05.2019**
(21) Anmeldenummer: 17202747.6
(22) Anmeldetag: 21.11.2017
(51) Int. Cl.: G01R 33/34, G01R 33/3875, G01R 33/3415

(54) **HF-FUSSSPULE MIT B0-SHIMSPULENANORDNUNG**

(71) Anmelder: Siemens Healthcare GmbH, 91052 Erlangen (DE)
(72) Erfinder: Biber, Stephan, 91056 Erlangen (DE)

(57) **Zusammenfassung**

Die Erfindung betrifft eine Fußspule für einen Magnetresonanztomographen. Die Fußspule weist eine Antennenspule zum Empfang von Magnetresonanzsignalen, eine erste Shimspule zum Erzeugen eines lokalen statischen Magnetfeldes und eine Stützvorrichtung zum Anordnen der Antennenspule und der Shimspule in einer vorbestimmten Position relativ zu einem in der Fußspule anordenbaren Fuß auf.

## Beschreibung

Die Erfindung betrifft eine Fußspule für einen Magnetresonanztomographen.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden. Die Empfangsantennen können auch in einer Patientenliege verbaut sein.

Protonen im Fett haben eine etwas andere Elektronenkonfiguration in der Umgebung als im Wassermolekül, was zu einer geringen Frequenzverschiebung der Larmorfrequenz führt. Dieser Effekt kann durch geeignete Verfahren genutzt werden, das allgegenwärtige Fett in Magnetresonanzaufnahmen auszublenden. Wegen der geringen Frequenzverschiebung sind diese Verfahren jedoch sehr empfindlich auf Variationen des statischen BO-Magnetfeldes. Die in heutigen Magnetresonanzsystemen erreichte Homogenität wird aber durch die Eigenschaften des Körpers gestört, da nicht alle Gewebetypen des menschlichen Körpers gleiche Permeabilität aufweisen. Dies ist besonders in Körperteilen kritisch, in denen Knochen, Muskeln, Sehnen, Fett in engem Raum aufeinandertreffen. Dies betrifft insbesondere den Knöchel, der aufgrund der hohen Belastungen im Sport auch häufig verletzt wird und entsprechende Magnetresonanzuntersuchungen des Bänderapparates erfordert.

Es sind Magnetresonanzsysteme bekannt, bei denen das statische BO-Magnetfeld durch Spulensysteme in der Patientendurchführung korrigiert wird, was aber mit erheblichem konstruktivem Aufwand verbunden ist.

Aus der Druckschrift DE 102012206300 B3 ist eine Shimspulenanordnung für eine Extremität eines Patienten bekannt, die eine Aufnahme für die Extremität umgebend angeordnet ist. Zwei ebene Shimspulen sind entlang des Umfangs der Aufnahme angeordnet und mehrere, in der Richtung des Grundmagnetfeldes der Magnetresonanzeinrichtung aufeinanderfolgende, zu der Richtung des Grundmagnetfeldes der Magnetresonanzeinrichtung senkrechte Spulenebenen mit Shimspulen sind vorgesehen.

Aus der Druckschrift DE 102011077724 A1 ist eine Kopfspule mit einer lokalen Shimspule bekannt.

Es stellt sich daher die Aufgabe, eine Vorrichtung bereitzustellen, um mit einem Magnetresonanztomographen detaillierte Aufnahmen des Fußes bereitstellen zu können.

Diese Aufgabe wird durch eine erfindungsgemäße Fußspule nach Anspruch 1 gelöst.

Die erfindungsgemäße Fußspule weist eine Antennenspule zum Empfang von Magnetresonanzsignalen und eine erste Shimspule zum Erzeugen eines lokalen statischen Magnetfeldes auf. Es ist dabei auch denkbar, dass die Fußspule weiterhin eine Antennenspule zum Senden von Pulsen zum Anregen von Kernspins aufweist oder die Antennenspule zum Empfangen als auch zum Senden ausgelegt ist. Weiterhin weist die Fußspule eine Stützeinrichtung auf, an der die Antennenspule und die Shimspule angeordnet sind. Dabei ist die Stützeinrichtung dazu ausgelegt, die Antennenspule und die Shimspule in einer vorbestimmten Position relativ zu einem in der Fußspule anordenbaren Fuß zu positionieren. Beispielsweise kann die Stützeinrichtung aus festen oder teilelastischen Schalen bzw. Halbschalen oder einer Struktur bestehen, an dem die Antennenspule und die erste Shimspule befestigt sind. Wird der Fuß in die Stützeinrichtung oder zwischen zwei separate Teile der Stützeinrichtung gelegt, so befinden sich die Antennenspule und die Shimspule in vorbestimmter Position zu dem Fuß.

Auf vorteilhafte Weise ist eine erfindungsgemäße Fußspule in der Lage, durch eine an einer bestimmten Position am Fuß angeordnete Shimspule gezielt dort abweichende statische Magnetfeldstärken zu korrigieren.

Weitere vorteilhafte Ausführungsformen sind in den Unteransprüchen angegeben.

In einer denkbaren Ausführungsform ist die erste Shimspule im Wesentlichen flächig in einer ersten Ebene angeordnet. Unter im Wesentlichen flächig in der ersten Ebene angeordnet ist dabei so zu verstehen, dass die Shimspule sich nicht um mehr als 5%, 10%, 20 % oder 50% der größten Abmessung in der Ebene entlang des Normalenvektors der ersten Ebene aus der ersten Ebene erhebt. Beispielsweise ist für einen Wert von 20% eine kreisförmige Shimspule mit 50 mm Durchmesser an keiner Stelle mehr als 10 mm durch eine Krümmung von der Ebene entfernt.

Es ist auch möglich, dass die erste Shimpule mehrere Windungen aufweist und eine oder mehrere Windungen in der ersten Ebene angeordnet sind oder in der ersten Ebene und einer dazu parallelen beabstandeten Ebene. Die Windungen in den parallelen Ebenen sind dabei durch Leiterabschnitte der Windung elektrisch verbunden, die sich dabei im Wesentlichen parallel zu dem Normalenvektor erstrecken.

Eine ebene und flächige Shimspule stellt auf vorteilhafte Weise ein räumlich homogenes und einfach zu ermittelndes statische Magnetfeld bereit, wenn sie von Strom durchflossen wird.

In einer möglichen Ausführungsform der erfindungsgemäßen Fußspule ist die erste Ebene so in Bezug auf die Fußspule ausgerichtet, dass erste Ebene bei einer anwendungsgemäßen Anordnung der Fußspule in dem Magnetresonanztomographen im Wesentlichen senkrecht zu einer Richtung des statischen Magnetfeldes B0 des Magnetresonanztomographen ausgerichtet ist. Als anwendungsgemäß im Sinne der Erfindung wird eine Ausrichtung angesehen, bei der der Patient auf einem Patiententisch liegend mit der Körperachse von Kopf bis Fuß parallel zur Feldrichtung des Magnetfeldes B0 im Field of View ausgerichtet ist. Die erste Ebene ist dabei im Wesentlichen parallel zur Fußsohle. Als im Wesentlichen senkrecht wird eine Ausrichtung angesehen, bei der die Flächennormale zur ersten Ebene einen Winkel von kleiner als 30 Grad, 15 Grad, 10 Grad, oder 5 Grad mit einer Auftrittfläche der Fußsohle einschließt.

Auf vorteilhafte Weise erzeugt eine derartig angeordnete Spule im stromdurchflossenen Zustand ein Magnetfeld, das parallel bzw. antiparallel zum BO-Feld ausgerichtet ist und damit besonders effektiv Abweichungen korrigieren kann.

In einer denkbaren Ausführungsform der erfindungsgemäßen Fußspule ist die erste Ebene so in Bezug auf die Fußspule ausgerichtet, dass erste Ebene bei einer anwendungsgemäßen Anordnung der Fußspule in dem Magnetresonanztomographen parallel zu einer Richtung des statischen Magnetfeldes B0 des Magnetresonanztomographen ausgerichtet ist. Die erste Ebene ist dabei im Wesentlichen senkrecht zur Fußsohle.

Auf vorteilhafte Weise kann diese Spulenform tangentiale Feldkorrekturen für Strukturen entlang der Fußknochen bzw. parallel zur Fußsohle erzeugen.

In einer möglichen Anwendungsform der erfindungsgemäßen Fußspule weist die Fußspule eine zweite Shimspule auf. Die zweite Shimspule ist im Wesentlichen flächig in einer zweiten Ebene angeordnet ist. Zu dem Begriff im Wesentlichen Flächig angeordnet gilt das zuvor angeführte. Dabei ist die zweite Ebene im Wesentlichen parallel zu der ersten Ebene ausgerichtet, d.h. die erste Ebene schließt mit der zweiten Ebene einen Winkel von kleiner als 30 Grad, 15 Grad, 10 Grad, oder 5 Grad ein oder ist auch parallel im geometrischen Sinn. Dabei sind die Begrifflichkeiten für die erste Shimspule und die zweite Shimspule austauschbar, jedoch sind die erste Shimspule und die zweite Shimspule nicht identisch.

Zwei parallele Spulen erlauben durch die Wechselwirkung der von ihnen bei Stromdurchfluss erzeugten Magnetfelder eine Vielzahl unterschiedlicher Konfigurationen zur Kompensation komplexer Feldstörung durch die unterschiedlichen Bestandteile des Fußes. Beispielhafte Konfigurationen sind nachfolgend beschrieben.

In einer denkbaren Ausführungsform der erfindungsgemäßen Fußspule ist eine Schnittmenge einer Projektion einer von der ersten Shimspule umschlossenen Fläche entlang eines Normalenvektors der ersten Ebene auf die zweite Ebene mit einer von der zweiten Shimspule umschlossenen Fläche nicht leer. Mit anderen Worten, die erste Shimspule und die zweite Shimspule sind nicht nebeneinander angeordnet, sondern stehen sich derart gegenüber, dass ihre Flächen bei Projektion auf die erste Ebene und oder zweite Ebene überlappen. Vorzugsweise ist entspricht dabei der Überlapp einem Anteil von mehr als 50%, 70% oder 90% der von der Spule umschlossenen Fläche.

Auf vorteilhafte können gegenüberliegende Spulenpaare, unter speziellen geometrischen Eigenschaften auch als Helmholtzspulen bezeichnet, ein besonders homogenes Feld zwischen den Spulen erzeugen zur gleichmäßigen Korrektur im eingeschlossenen Volumen.

In einer möglichen Form der erfindungsgemäßen Fußspule weist die Fußspule einen Shimanschluß zum Anschließen einer Stromquelle für die erste und die zweite Shimspule auf. Die erste Shimspule und die zweite Shimspule stehen derart in elektrischer Verbindung, dass eine an dem Shimanschluß angeschlossene Stromquelle in der von der ersten Shimspule umschlossenen Fläche ein Magnetfeld erzeugt, dessen Magnetfeldkomponente senkrecht zu der umschlossenen Fläche und entgegengesetzt gerichtet ist zu einer von der zweiten Shimspule erzeugten Magnetfeldkomponente senkrecht zu einer von der zweiten Shimspule umschlossenen Flache. Mit anderen Worten, die von der ersten Shimspule und der zweiten Shimspule erzeugten Magnetfelder weisen jeweils Komponenten senkrecht zu der von der jeweiligen Spule umschlossenen Fläche auf. Diese senkrechten Komponenten haben aufgrund der elektrischen Verschaltung der ersten Shimspule und der zweiten Shimspule miteinander jeweils entgegengesetzte Richtung.

Auf vorteilhafte Weise kann durch diese entgegengesetzte Ausrichtung erreicht werfen, dass sich in einem bestimmten Volumen zwischen den Spulen die erzeugten Korrekturfelder ganz oder zumindest in der senkrechten Komponente aufheben, während in benachbarten Bereichen eine Korrektur vorgenommen wird.

In einer denkbaren Ausführungsform der erfindungsgemäßen Fußspule weist die Fußspule einen Shimanschluß zum Anschließen einer Stromquelle für die erste Shimspule und die zweite Shimspule auf. Die erste Shimspule und die zweite Shimspule stehen derart in elektrischer Verbindung, dass eine an dem Shimanschluß angeschlossene Stromquelle in der von der ersten Shimspule umschlossenen Fläche ein Magnetfeld erzeugt, dessen Magnetfeldkomponente senkrecht zu der umschlossenen Fläche und parallel zu einer Magnetfeldkomponente senkrecht zu einer von der zweiten Shimspule umschlossenen Flache ist. Mit anderen Worten, die von der ersten Shimspule und der zweiten Spule erzeugten Magnetfelder weisen jeweils Komponenten senkrecht zu der von der jeweiligen Shimspule umschlossenen Fläche auf. Diese senkrechten Komponenten haben aufgrund der elektrischen Verschaltung der ersten Shimspule und der zweiten Shimspule miteinander jeweils gleiche Richtung.

Die gleichgerichteten Felder erlauben es beispielsweise bei einander gegenüberliegend angeordneten Shimspulen, ähnlich einem Helmholtzspulenpaar, besonders homogene Felder für eine Korrektur auszubilden.

In einer möglichen Ausführungsform der erfindungsgemäßen Fußspule weist die Fußspule als Stützeinrichtung eine erste Halbschale und eine zweite Halbschalen auf. Als Halbschale wird gemäß der Erfindung jegliche Stützeinrichtung angesehen, die ausgelegt ist, die erste und/oder die zweite Shimspule bei einem Fuß in der Fußspule in einer vorbestimmten Position zu dem Fuß anzuordnen und die ausgelegt ist, zur Aufnahme des Fußes in von mindestens einer weiteren Halbschale bzw. einem weiteren Teil der Stützeinrichtung getrennt zu werden und es so erlaubt, den Fuß zu positionieren. Denkbar ist jedoch auch eine Konstruktion der Fußspule, die mehr als zwei Halbschalen aufweist. Die Halbschale kann dabei aus einem oder mehreren starren oder teilflexiblen Materialien bestehen, die mit einer Magnetresonanzmessung kompatibel sind.

Die erste Halbschale und die zweite Halbschale sind lösbar für eine Magnetresonanzaufnahme mit einem Fuß dazwischen miteinander verbindbar. Die erste Shimspule weist ein erstes Shimspulensegmente und ein zweites Shimspulensegment auf. Als Shimspulensegment sind hier Teile der Shimspule bezeichnet, die erst in Zusammenwirken, insbesondere in elektrischer Verbindung miteinander, die erste Shimspule bilden. Dabei ist das erste Shimspulensegment in der ersten Halbschale angeordnet und das zweite Shimspulensegment in der zweiten Halbschale. Denkbar ist es beispielsweise, dass das erste Shimspulensegment und das zweite Shimspulensegment durch eine flexible Kabelverbindung miteinander verbunden sind und so die erste Halbschale und die zweite Halbschale durch aufklappen voneinander getrennt werden können, um einen Fuß zu positionieren.

In einer denkbaren Ausführungsform der erfindungsgemäßen Fußspule weisen die erste Halbschale und die zweite Halbschale jeweils Kontaktelemente auf. Als Kontaktelemente werden hierbei alle lösbaren Verbindungselemente angesehen, die in Zusammenwirken eine elektrische Verbindung herstellen. Denkbar sind beispielsweise Schleifkontakte, Stecker und Buchse in unterschiedlichen Ausführungsformen, leitende Druckknöpfe oder vergleichbares. Die Kontaktelemente sind so ausgelegt und angeordnet, dass das erste Shimspulensegment und das zweite Shimspulensegment durch das gegenseitige Eingreifen der Kontaktelemente elektrisch miteinander verbunden werden, wenn die erste Halbschale und die zweite Halbschale für eine Magnetresonanztomographie zueinander gefügt werden. Bevorzugter Weise ist dabei zum Schließen der elektrischen Verbindung keine separate Betätigung erforderlich, es wäre aber auch beispielsweise das Zusammenfügen eines Stecker/Buchse-Paares oder eines Druckknopfes denkbar.

Auf vorteilhafte Weise ermöglicht die Unterteilung der Fußspule in mehrere Halbschalen ein Anordnen des Fußes in der Fußspule. Durch die Segmentierung der Shimspule in mehrere Segmente in unterschiedlichen Halbschalen wird die Handhabung der Fußspule am Patienten erleichtert und gleichzeitig das BO-Shimming mit vergleichsweise wenigen Einschränkungen zur Geometrie ermöglicht.

In einer möglichen Ausführungsform der erfindungsgemäßen Fußspule ist die erste Shimspule bei erfindungsgemäßem Gebrauch der Fußspule zu der Fußsohle benachbart angeordnet, wobei die erste Ebene im Wesentlichen parallel zur Fußsohle angeordnet ist. Mit anderen Worten, die erste Shimspule ist aus Sicht des Patienten unter der Fußsohle angeordnet.

Auf vorteilhafte Weise erlaubt die Shimspule unter der Fußsohle eine Korrektur des Magnetfeldes, die im Wesentlichen homogen durch den gesamten Vorderfuß hindurch erfolgt.

In einer denkbaren Ausführung der erfindungsgemäßen Fußspule umschließt die erste Shimspule bei erfindungsgemäßem Gebrauch der Fußspule den Vorderfuß. Mit anderen Worten, die Spulenwicklung der ersten Shimspule ist außenumfänglich um den Vorderfuß angeordnet, sodass ein von der ersten Magnetspule erzeugtes Magnetfeld in der Mitte der von der Spule umschlossenen Fläche parallel zu den Knochen des Vorderfußes verläuft.

Eine um den Vorderfuß gelegte Shimspule ermöglicht auf vorteilhafte Weise eine homogene Feldkorrektur im Inneren des Vorderfußes entlang der Erstreckung der Knochen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung eines Magnetresonanztomographen mit einer erfindungsgemäßen Fußspule;
- Fig. 2: eine schematische Darstellung eines Fußes und der für die Magnetresonanzabbildung kritischen Bereiche;
- Fig. 3: eine schematische Darstellung von Antennenspulen einer erfindungsgemäßen Fußspule im Querschnitt;
- Fig. 4: eine mögliche Anordnung von Shimspulen in einer erfindungsgemäßen Fußspule;
- Fig. 5: eine mögliche Anordnung von Shimspulen in einer erfindungsgemäßen Fußspule;

- Fig. 6: eine mögliche Anordnung von Shimspulen in einer erfindungsgemäßen Fußspule.

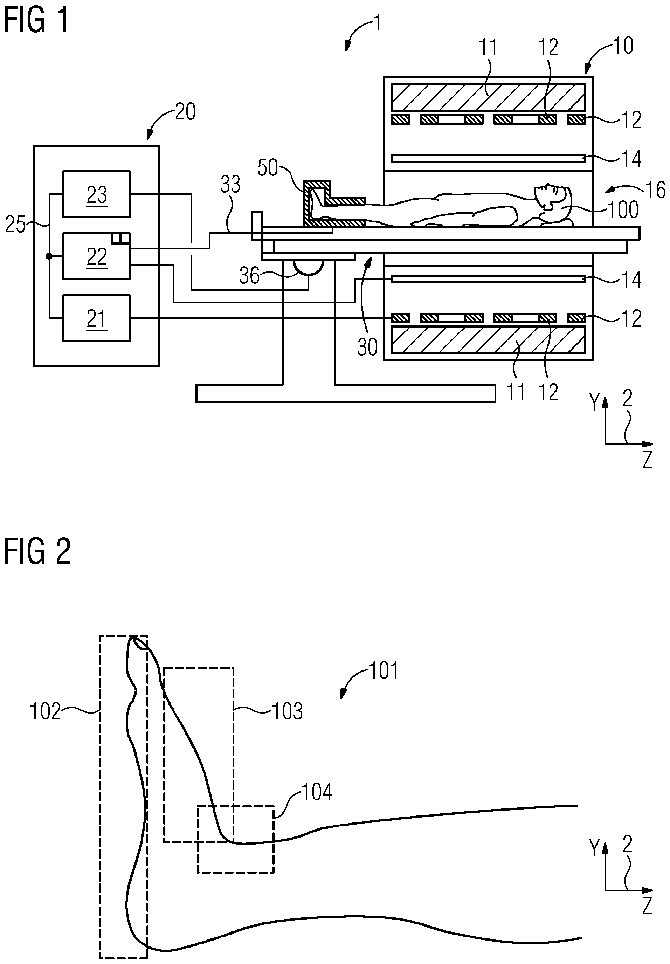

Fig. 1 zeigt eine schematische Darstellung einer Ausführungsform eines Magnetresonanztomographen 1 mit einer erfindungsgemäßen Fußspule 50.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich, auch als Field of View (FoV) bezeichnet, erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungspulse können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

An dem Patienten 100 ist eine erfindungsgemäße Fußspule 50 angeordnet, die über eine Anschlussleitung 33 mit der Hochfrequenzeinheit 22 verbunden ist.

In Fig. 2 ist ein Fuß 101 eines Patienten 100 schematisch dargestellt. Für das Magnetfeld B0 sind dabei insbesondere Bereiche kritisch, für die ein Sprung der magnetischen Permeabilität µ in Längsrichtung 2 entlang der z-Achse auftritt und damit das BO-Feld inhomogen wird. Ist der Patient 100, wie in Fig. 1 dargestellt, in dem Magnetresonanztomographen 1 gelagert, so treten derartige Diskontinuitäten als Diskontinuität an der Fußsohle 102, dem Fußrücken 103 und dem Fußgelenk 104 auf, da hier in Längsrichtung 2 ein plötzlicher Übergang von dem Medium Luft in den Fuß stattfindet, der unterschiedliche Gewebe wie Fett, Muskeln oder Knochen aufweist.

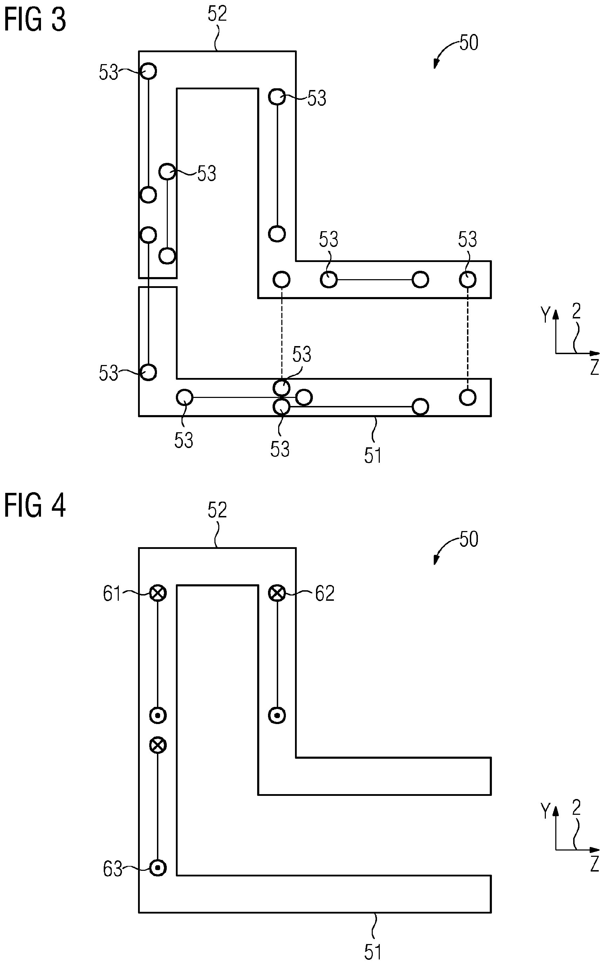

In Fig. 3 sind denkbare Anordnungen von Antennenspulen 53 in einer erfindungsgemäßen Fußspule 50 schematisch dargestellt. Die Ausrichtung der Fußspule 50 entspricht dabei der in Fig. 2 angegebenen Ausrichtung des Fußes, der bei erfindungsgemäßem Gebrauch der Fußspule wie in Fig. 1 angedeutet in der gleichen Lage im Inneren der Fußspule 50 angeordnet ist. Der Fuß ist aus Gründen der Übersicht nicht dargestellt.

Der Kreis bei einer Antennenspule 51 bzw. einer Shimspule in den nachfolgenden Figuren deutet dabei jeweils den Querschnitt des Leiters bzw. der Wicklung an und der verbindende Strich den weiteren Verlauf der Wicklung vor bzw. hinter der Schnittebene.

Vorzugsweise weist die Fußspule 50 eine mehrteilige Stützkonstruktion auf, an der oder in der die Antennenspulen 53 und die Shimspulen angeordnet sind. Dabei kann die Stutzkonstruktion in eine erste Halbschale 51 und eine zweite Halbschale 52 unterteilt sein, die miteinander auf lösbare Weise verbindbar sind, sodass der Fuß 101 einfach in der Fußspule 50 angeordnet werden kann. Dabei kann die erste Halbschale 51 wie in der Darstellung als untere Halbschale ausgeführt sein und die zweite Halbschale 52 als obere Halbschale, es ist aber beispielsweise auch eine Teilung in eine rechte und eine linke Halbschale denkbar oder in mehrere Einzelteile. Zur Verbindung können beispielsweise Schnallen, Stifte, Bänder und andere Verbindungs- und Führungselemente vorgesehen sein. Auch ist es denkbar, dass Antennenspulen 53 und/oder Shimspulen aus mehreren Segmenten in unterschiedlichen Halbschalen bestehen, die durch lösbare elektrische Verbindungen beim Zusammenfügen der Halbschalen zu jeweils vollständigen Antennenspulen 53 zusammengefügt werden.

In der Fußspule 50 sind Antennenspulen 53 in unterschiedlichen Konfigurationen denkbar. Diese können beispielsweise parallel zur Fußsohle oder dem Fußrücken angeordnet sein. Antennenspulen können auch parallel zu beiden Seiten der Wade in horizontaler oder vertikaler Richtung vorgesehen sein. Die Antennenspulen können als Ringspulen oder als Sattelspulen ausgeführt sein, um eine maximale Sensitivität in unterschiedlichen Bereichen des Fußes aufzuweisen. Schließlich ist es auch denkbar, dass eine oder mehrere Antennenspulen 53 außenumfänglich um den Fuß oder den Unterschenkel angeordnet sind. Dabei ist es denkbar, dass die Antennenspule 53 in mehrere voneinander durch lösbare Kontakte verbindbare Segmente aufgeteilt ist.

In Fig. 4 ist eine mögliche Anordnung von Shimspulen in einer erfindungsgemäßen Fußspule 50 dargestellt. Gleiche Referenzzeichen bezeichnen gleiche Gegenstände. Der Übersichtlichkeit halber sind die Antennenspulen 53 in dieser und den nachfolgenden Figuren nicht dargestellt. Es ist aber in einer Ausführungsform auch denkbar, dass die Antennenspulen gleichzeitig als Shimspulen dienen, indem sie mit einem Gleichstrom beaufschlagbar sind.

Die in Fig. 4 dargestellten Shimspulen werden nachfolgend als senkrechte Shimspulen 61, 62, 63 bezeichnet, da sie im Wesentlichen parallel zu der x-y-Ebene angeordnet sind, die bei einem Patienten 1000, der wie in Fig. 1 im Magnetresonanztomographen 1 positioniert ist, parallel zur Fußsohle und insbesondere senkrecht zur Richtung des statischen Magnetfeldes B0 ausgerichtet ist.

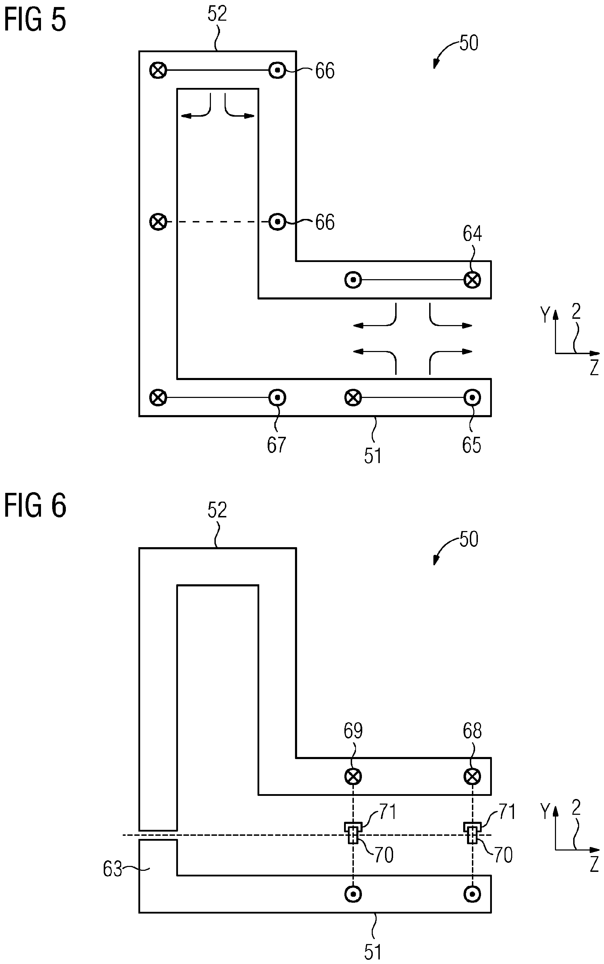

Die in den Ansprüchen genannte erste und zweite Shimspule können wahlweise senkrechte Shimspulen 61, 62, 63 oder nachfolgend in Fig. 5 dargestellte parallele Shimspulen 64, 65, 66, 67 sein.

Dabei können eine oder mehrere senkrechte Shimspulen 61, 63 an der Fußsohle und parallel dazu angeordnet sein. Eine mögliche elektrische Stromrichtung des in den senkrechten Shimspulen 61, 62, 63 fließenden Stromes ist durch das X bzw. den Punkt im Querschnitt der Shimspule angegeben. Eine oder mehrere senkrechte Shimspulen 62 sind dabei an und parallel zu dem Fußrücken angeordnet.

Dabei können die senkrechten Shimspulen 61 und 62 elektrisch in Serie geschaltet sein, sodass der gleiche Strom durch die Shimspulen 61 und 62 fließt. Die senkrechten Shimspulen 61, 62 bilden dabei ein Helmholtz-Spulenpaar, das ein besonders homogenes Feld im Vorderfuß erzeugt, das je nach Stromrichtung, das BO-Feld im Vorderfuß verstärkt oder abschwächt.

Bei entgegengesetzter Stromrichtung ist es auch denkbar, dass das statische Magnetfeld insbesondere an der Oberfläche des Fußes, z.B. am Fußrücken und an der Fußsohle verstärkt bzw. abgeschwächt wird.

Es ist auch denkbar, dass die senkrechte Shimspule 63 mit einer weiteren um den Unterschenkel bzw. den Knöchel außenumfänglichen senkrechten Shimspule wie zu den senkrechten Shimspulen 61, 62 beschrieben als Helmholtz-Paar zusammenwirkt.

Die in Fig. 5 dargestellten Shimspulen werden im Folgenden als parallele Shimspulen 64,65,66,67 bezeichnet, da sie im Wesentlichen parallel zur der Feldrichtung des statischen Magnetfeldes B0 in Längsrichtung 2 ausgerichtet sind, d.h. die Wicklung der Shimspule befindet sich in einer Fläche, die sich im Wesentlichen parallel zu der Längsrichtung 2 erstreckt. Dabei können die parallelen Shimspulen wie in Fig. 5 horizontal in der x-z-Ebene ausgerichtet sein, es ist aber auch eine Anordnung in der y-z-Ebene oder gekrümmten Flächen parallel zu der Längsrichtung 2 denkbar.

Bei entgegengesetzter Stromrichtung, wie für die parallelen Shimspulen 64, 65 dargestellt, sind die erzeugten Felder entgegengesetzt. Durch Überlagerung der Felder treten dabei in der Mitte zwischen den vertikalen Spulen 64, 65 Felder auf, die sich in Längsrichtung erstrecken. Auf diese Weise lässt sich eine tiefenabhängige Korrektur des statischen Magnetfeldes B0 herbeiführen. Auch hier ist wieder eine Serienschaltung der Spulen mit entsprechender Polarität denkbar. Die parallele Shimspule 66 kann an der Spitze des Fußes 101 oder auch um die Mitte herum angeordnet sein. Es ist auch denkbar, dass die parallele Shimspule 66 mehrere Windungen aufweist, die über mehrere parallele Ebenen verteilt sind, die entlang des Vorderfußes angeordnet sind.

Bei gleicher Stromrichtung bilden die parallelen Shimspulen 64, 65 bzw. 66, 67 wieder Helmholtzspulen-Paare mit einem weitgehend homogenen Magnetfeld im Zwischenraum. Die Korrektur des BO-Feldes erfolgt dabei durch Vektoraddition und Betragsbildung des resultierenden Magnetfeldes. Es ist dabei auch denkbar, dass beide parallele Shimspulen 66, 67 außenumfänglich um den Vorderfuß angeordnet sind.

In Fig. 6 ist eine weitere denkbare Anordnung von senkrechten Shimspulen 68, 69 in einer erfindungsgemäßen Fußspule 50 dargestellt, bei der die senkrechten Shimspulen 68, 69 außenumfänglich um den Unterschenkel angeordnet sind. Diese bilden bei gleicher Stromrichtung, insbesondere wenn die beiden senkrechten Shimspulen 68, 69 elektrisch in Serie geschaltet sind, wieder eine Art Helmholtzspulen-Paar mit homogenem Korrekturmagnetfeld parallel zu dem statischen Magnetfeld B0.

In dieser Fig. 6 ist auch schematisch dargestellt, dass die Shimspulen segmentiert sein können, wobei jeweils ein Segment in der ersten Halbschale 51 und der zweiten Halbschale 52 angeordnet ist. Beide Spulensegmente werden durch Kontaktelemente, beispielsweise Stecker 70 und Buchse 71 zu einer geschlossenen Shimspule elektrisch verbunden.

Die in den Fig. 4 bis 6 dargestellten Konfigurationen der Shimspulen in der erfindungsgemäßen Fußspule 50 schließen sich dabei nicht gegenseitig aus, sondern können auf unterschiedliche Weise miteinander kombiniert werden, um besonders vorteilhafte Magnetfelder zur Kompensation von Inhomogenitäten des BO-Feldes zu erzeugen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Fußspule für einen Magnetresonanztomographen (1), wobei die Fußspule (50) eine Antennenspule (53) zum Empfang von Magnetresonanzsignalen, eine erste Shimspule zum Erzeugen eines lokalen statischen Magnetfeldes und eine Stützvorrichtung zum Anordnen der Antennenspule (53) und der ersten Shimspule in einer vorbestimmten Position relativ zu einem in der Fußspule (50) anordenbaren Fuß (101) aufweist.

2. Fußspule nach Anspruch 1, wobei die erste Shimspule im Wesentlichen flächig in einer ersten Ebene oder in mehreren parallelen Ebenen angeordnet ist.

3. Fußspule nach einem der Ansprüche 1 oder 2, wobei die erste Ebene in Bezug auf die Fußspule (50) so ausgerichtet ist, dass die erste Ebene bei einer anwendungsgemäßen Anordnung der Fußspule (50) in dem Magnetresonanztomographen (1) im Wesentlichen senkrecht zu einer Richtung des statischen Magnetfeldes B0 des Magnetresonanztomographen ausgerichtet ist.

4. Fußspule nach einem der Ansprüche 1 oder 2, wobei die erste Ebene in Bezug auf die Fußspule (50) so ausgerichtet ist, dass die erste Ebene bei einer anwendungsgemäßen Anordnung der Fußspule (50) in dem Magnetresonanztomographen (1) im Wesentlichen parallel zu einer Richtung des statischen Magnetfeldes B0 des Magnetresonanztomographen (1) ausgerichtet ist.

5. Fußspule nach einem der Ansprüche 2 bis 4, wobei die Fußspule (50) eine zweite Shimspule aufweist, wobei die zweite Shimspule im Wesentlichen flächig die in einer zweiten Ebene angeordnet ist, wobei die zweite Ebene im Wesentlichen parallel zu der ersten Ebene ausgerichtet ist.

6. Fußspule nach Anspruch 5, wobei eine Schnittmenge einer Projektion einer von der ersten Shimspule umschlossenen Fläche entlang eines Normalenvektors der ersten Ebene auf die zweite Ebene mit einer von der zweiten Shimspule umschlossenen Fläche nicht leer ist.

7. Fußspule nach Anspruch 6, wobei die Schnittmenge die von der zweiten Shimspule umschlossene Fläche im Wesentlichen umfasst.

8. Fußspule nach einem der Ansprüche 5 bis 7, wobei die Fußspule (50) einen Shimanschluß zum Anschließen einer Stromquelle für die erste Shimspule und die zweite Shimspule aufweist, wobei die erste Shimspule und die zweite Shimspule derart in elektrischer Verbindung stehen, dass eine an dem Shimanschluß angeschlossene Stromquelle in der von der ersten Shimspule umschlossenen Fläche ein Magnetfeld erzeugt, dessen Magnetfeldkomponente senkrecht zu der umschlossenen Fläche und entgegengesetzt gerichtet ist zu einer von der zweiten Shimspule erzeugten Magnetfeldkomponente senkrecht zu einer von der zweiten Shimspule umschlossenen Flache.

9. Fußspule nach einem der Ansprüche 5 bis 7, wobei die Fußspule (50) einen Shimanschluß zum Anschließen einer Stromquelle für die erste Shimspule und die zweite Shimspule aufweist, wobei die erste Shimspule und die zweite Shimspule derart in elektrischer Verbindung stehen, dass eine an dem Shimanschluß angeschlossene Stromquelle in der von der ersten Shimspule umschlossenen Fläche ein Magnetfeld erzeugt, dessen Magnetfeldkomponente senkrecht zu der umschlossenen Fläche und gleichgerichtet zu einer Magnetfeldkomponente senkrecht zu einer von der zweiten Shimspule umschlossenen Flache ist.

10. Fußspule nach einem der vorhergehenden Ansprüche, wobei die Fußspule (50) eine erste Halbschale (51) und eine zweite Halbschale (52) aufweist, die lösbar für eine Magnetresonanzaufnahme mit einem Fuß (101) dazwischen miteinander verbindbar sind, wobei die erste Shimspule ein erstes Shimspulensegmente und ein zweites Shimspulensegment aufweist, wobei das erste Shimspulensegment in der ersten Halbschale (51) angeordnet ist und das zweite Shimspulensegment in der zweiten Halbschale (52).

11. Fußspule nach Anspruch 10, wobei die erste Halbschale (51) und die zweite Halbschale (52) jeweils Kontaktelemente aufweisen, die ausgelegt und so angeordnet sind, das erste Shimspulensegment und das zweite Shimspulensegment durch das gegenseitige Eingreifen der Kontaktelemente elektrisch miteinander verbunden werden, wenn die erste Halbschale (51) und die zweite Halbschale (52) für eine Magnetresonanztomographie zueinander gefügt werden.

12. Fußspule nach einem der Ansprüche 2 bis 11, wobei die erste Shimspule bei erfindungsgemäßem Gebrauch der Fußspule (50) zu der Fußsohle benachbart angeordnet ist, wobei die erste Ebene im Wesentlichen parallel zur Fußsohle angeordnet ist.

13. Fußspule nach einem der Ansprüche 1 bis 11, wobei die erste Shimspule bei erfindungsgemäßem Gebrauch der Fußspule (50) den Vorderfuß umschließt.
